Europäisches Patentamt

European Patent Office

Office européen des brevets

(19)

(11) **EP 0 544 728 B1**

(12) **EUROPÄISCHE PATENTSCHRIFT**

(45) Veröffentlichungstag und Bekanntmachung des Hinweises auf die Patenterteilung:
**16.04.1997 Patentblatt 1997/16**

(21) Anmeldenummer: **91914751.2**

(22) Anmeldetag: **19.08.1991**

(51) Int Cl.[6]: **H02M 7/54**, H02P 6/00, H03B 21/00

(86) Internationale Anmeldenummer:
**PCT/EP91/01567**

(87) Internationale Veröffentlichungsnummer:
**WO 92/03871 (05.03.1992 Gazette 1992/06)**

(54) **GENERATOR FÜR AMPLITUDENGEKOPPELTE SPANNUNGEN**

GENERATOR FOR AMPLITUDE-COUPLED VOLTAGES

GENERATEUR DE TENSIONS A AMPLITUDES COUPLEES

(84) Benannte Vertragsstaaten:
**AT DE ES FR GB NL**

(30) Priorität: **25.08.1990 DE 4026987**
**17.09.1990 DE 4029409**

(43) Veröffentlichungstag der Anmeldung:
**09.06.1993 Patentblatt 1993/23**

(73) Patentinhaber: **DEUTSCHE THOMSON-BRANDT GMBH**
**78048 Villingen-Schwenningen (DE)**

(72) Erfinder: **GLEIM, Günter**
**D-7730 Villingen (DE)**

(56) Entgegenhaltungen:
EP-A- 0 339 381      DE-A- 2 416 266
DE-A- 2 513 758      DE-C- 871 025
FR-A- 155 923

- **PATENT ABSTRACTS OF JAPAN, vol. 9, No. 89
(E-309)(1812) 18 April 1985 & JP 59 218009**

**Beschreibung**

Die Erfindung betrifft ein Verfahren zur Erzeugung amplitudengekoppelter Spannungen gemäß dem Oberbegriff des Hauptanspruchs, sowie eine entsprechende Vorrichtung gemäß dem Oberbegriff des ersten Vorrichtungsanspruchs.

Unter dem Begriff "amplitudengekoppelt" ist in diesem Zusammenhang zu verstehen, daß durch ein einziges Ansteuersignal eine gemeinsame Änderung der Scheitelpunktwerte der elektrischen Spannungen bewirkt wird.

Es ist allgemein bekannt, daß für verschiedene Anwendungen elektrische Spannungen mit einem vorgegebenem zeitlichen Verlauf vorliegen müssen, die amplitudengekoppelt sind.

So werden beispielsweise für die Ansteuerung von mehrsträngigen Motoren mehrere amplituden- und phasengekoppelte Spannungen benötigt, mit möglichst sinusförmigem Verlauf.

Durch die DE-OS 2 416 266 ist bereits bekannt, eine einzige Spannungsquelle zu verwenden, die eine Gesamtspannung abgibt, um drei Feldwicklungen zu bestromen. Es ist dieser Schrift jedoch nicht zu entnehmen, daß der Spannungswert der Gesamtspannung veränderbar ist. Weiterhin ist der deutschen Offenlegungsschrift nicht zu entnehmen, daß Entnahmespannungen erzeugt werden, aus denen durch Schaltvorgänge Ansteuersignale für einen Motor erzeugt werden.

Die FR 1 554 923 beschreibt eine Vorrichtung, die ein sinusartiges Signal erzeugt, indem Spannungen geeignet geschaltet werden. Auch wird eine Vorrichtung beschrieben, die ein dreiphasiges Ausgangssignal erzeugt. Jedoch ist dieser Schrift nicht zu entnehmen, daß durch diese Ausgangssignale ein Motor derart angesteuert werden soll, daß ihm während der Anlaufphase Signale einer ersten Kurvenform und während eines Normalbetriebes Signale einer zweiten Kurvenform zugeführt werden sollen.

Die Schrift EP 0 339 381 stellt zwar eine Schaltungsanordnung zur Erzeugung phasenverschobener sinusförmiger Spannungen vor, jedoch wird hier nicht beschrieben, einen Motor mit Signalen unterschiedlicher Kurvenform anzusteuern.

Aus der DE-OS 38 14 562 ist eine Schaltungsanordnung zur Erzeugung phasenverschobener, sinusförmiger Spannungen bekannt. Das dort vorgestellte System zeichnet sich dadurch aus, daß ein Netzwerk aus Widerständen verwendet wird, die zu einem geschlossenem Kreis in Serie geschaltet sind und daß die sinusförmigen Spannungen an Verbindungspunkten der zusammengeschalteten Widerstände abnehmbar sind. Dabei wird eine Gleichspannung in zyklischer Reihenfolge derart an das Widerstandsnetzwerk geschaltet, so daß zwischen den Polen der Gleichspannung zwei parallele Zweige mit gleicher Anzahl von Widerständen liegen.

Durch das dort vorgestellte System kann lediglich ein sinusförmiger Spannungsverlauf angenähert werden.

Bei anderen Anwendungen ist es wünschenswert, mehrere amplitudengekoppelte Spannungen zu liefern, die vorgegebenen zeitlichen Verläufen genügen, jedoch nicht zwangsläufig phasengekoppelt sind.

Es ist somit Aufgabe des erfindungsgemäßen Verfahrens bzw. der erfindungsgemäßen Vorrichtung, einen mehrsträngigen Elektromotor in Abhängigkeit vom Betriebszustand auf zuverlässige Weise anzusteuern.

Diese Aufgabe wird durch das erfindungsgemäße Verfahren gemäß dem Hauptanspruch bzw. durch die erfindungsgemäße Vorrichtung gemäß dem ersten Vorrichtungsanspruch gelöst.

Vorteilhafte Ausgestaltungen der Erfindung sind in den Unteransprüchen gekennzeichnet.

Gemäß der vorliegenden Erfindung wird eine erste Kurvenform für die Start- bzw. Anlaufphase und eine zweite Kurvenform für den Normalbetrieb eines Elektromotors mit einem oder mehereren Strängen verwendet. Derartige Ansteuerungen können durch die erfindungsgemäße Vorrichtung oder durch andere geeignete Vorrichtungen durchgeführt werden. Die Unterscheidung zwischen Anlaufphase und Normalbetrieb kann beispielsweise anhand einer Schwelldrehzahl, einer Schwellastgröße und/oder weiterer Größen erfolgen, die Maße darstellen dafür, daß die Drehrichtung des Motors der gewünschten Drehrichtung entsprechen und/oder die erforderliche Laufruhe vorliegt.

Dabei kann eine Entnahmevorrichtung Entnahmespannungen abgeben, deren Werte durch ein einziges Ansteuersignal gemeinsam multiplikativ und/oder additiv geändert werden können und die einer oder mehreren vorgegebenen Kurvenformen entsprechen.

Durch ein zeitlich abgestimmtes Umschalten zwischen diesen Entnahmespannungen werden amplitudengekoppelte Ausgangsspannungen Ua1 ... Uax erzeugt, die mindestens einem vorgegebenem zeitlichen Verlauf f(t), entsprechen. D.h.

$$Ua1 = U \times f1(t+d1)$$

$$Ua2 = U \times f2(t+d2)$$

.

.

$$Uax = U \times fx(t+dx).$$

Enthält die Entnahmevorrichtung ein Netzwerk von Bauelementen, an die eine Gesamtspannung anschließbar ist und durch die an den Bauelementen Entnahmespannungen verursacht werden, so wird eine einfache und stabile Ausführung realisiert.

Die Steuerung der vorgegebenen zeitlichen Funktion durch einen Sensor, der die Wirkung der Ausgangsspannungen auf einen elektrischen Verbraucher, beispielsweise einen Motor, erfaßt, hat besonders den Vorteil, daß auch bei einer unterschiedlichen Drehzahl eines Motors die Ansteuerung optimal ist.

Dienen der Sensor und das Zeitglied gemeinsam zur Steuerung der Zeitfunktion, so ist neben der Steuerung aufgrund von Meßwerten eventuell eine zeitliche Interpolation zwischen Meßwerten möglich.

Wenn die Entnahmevorrichtung durch das elektronische Steuergerät derart angesteuert wird, daß die Entnahmespannungen vorgegebenen Werten entsprechen, hat das besonders den Vorteil, daß beliebige Kurvenformen der Ausgangsspannungen vorgegeben werden können.

Bei Verwendung einer Eingabevorrichtung, über die der zeitliche Verlauf der Ausgangsspannung vorgegeben werden kann, kann die erfindungsgemäße Vorrichtung bei verschiedenen Anwendungsgebieten universell eingesetzt werden.

Werden zusätzlich Dämpfungs- und/oder Verstärkungsmittel eingesetzt, die die Entnahmespannungen dämpfen bzw. verstärken können, so erlaubt die erfindungsgemäße Vorrichtung weiterhin, daß die mindestens eine Ausgangsspannung auch in ihrem Amplitudenverlauf variiert werden kann.

Neben der besseren Angleichung an einen vorgegebenen zeitlichen Verlauf gestattet eine Ausgestaltung der Erfindung weiterhin, daß mehrere zeitliche Verläufe mit ihren Scheitelwerten vorgegeben werden können, denen die amplitudengekoppelten Ausgangsspannungen folgen.

Wenn eine oder mehrere der Ausgangsspannungen zu verschiedenen Zeiten verschiedenen Kurvenformen und/oder zeitlichen Verläufen entsprechen, hat das u.a. den Vorteil, daß die Ausgangsspannungen während Anlauf oder Verzögerungsphasen des Elektromotors optimiert werden können.

Bevorzugte Ausführungsbeispiele der Erfindung sind in der Zeichnung dargestellt und werden im folgenden näher beschrieben.

Es zeigen

Figur 1    ein erstes Ausführungsbeispiel zur Ansteuerung eines dreisträngigen Motors,
Figur 2    einen vorgegebenen zeitlichen Verlauf mit Werten von Entnahme- und Einzelspannungen gemäß dem Ausführungsbeispiel nach Figur 1,
Figur 3    ein zweites Ausführungsbeispiel mit einstellbaren Bauelementen,
Figur 4    Ausgangssignale eines Sensors zur Erfassung von Drehzahl und/oder Position des Motors,
Figur 5    ein Motoransteuersignal mit einer ersten Kurvenform für die Startphase,
Figur 6    resultierende Spannungen bei einer Ansteuerung gemäß Figur 5,
Figur 7    ein Motoransteuersignal mit einer zweiten Kurvenform für den Normalbetrieb.

Bevor auf die Beschreibung der Ausführungsbeispiele näher eingegangen wird, sei darauf hingewiesen, daß die in den Figuren einzeln dargestellten Blöcke lediglich zum besseren Verständnis der Erfindung dienen. üblicherweise sind einzelne oder mehrere dieser Blöcke zu Einheiten zusammengefaßt. Diese können in integrierter oder Hypridtechnik oder aber als programmgesteuerte Mikrorechner, bzw. als Teil eines zu seiner Steuerung geeigneten Programmes realisiert sein.

Weiterhin sei darauf hingewiesen, daß die in den einzelnen Stufen enthaltenen Vorrichtungen und Elemente auch getrennt ausgeführt werden können.

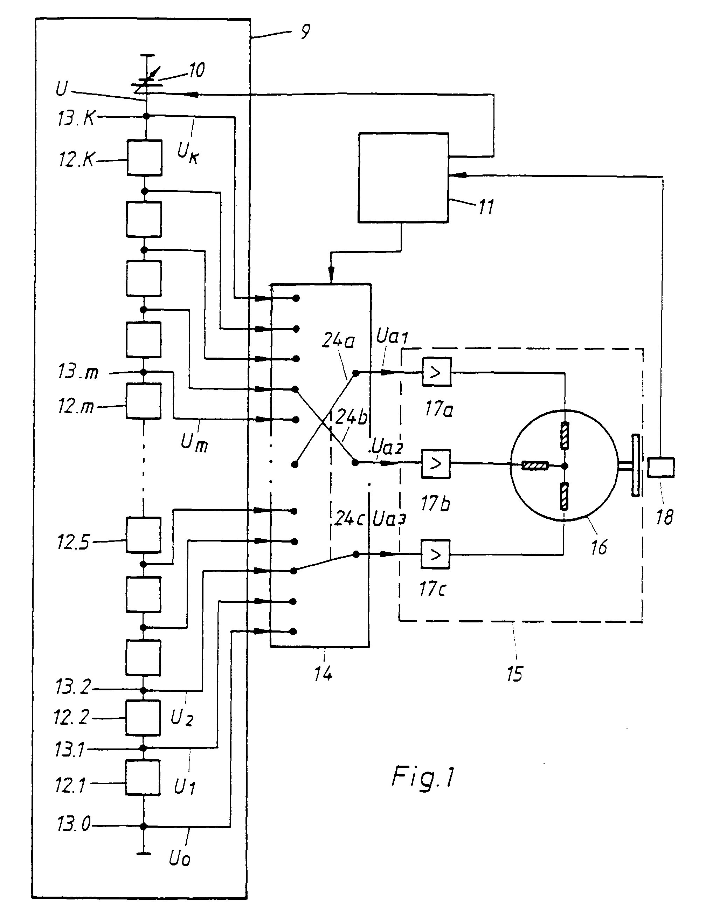

In Figur 1 ist eine Entnahmevorrichtung 9 dargestellt, die eine steuerbare Spannungsquelle 10, die in Abhängigkeit von Steuerimpulsen eines elektronischen Steuergerätes 11 eine Ausgangsspannung U abgibt, und ein Netzwerk aufweist, das aus Bauelementen 12.1 ... 12.k gebildet wird. Dadurch ergeben sich Entnahmepunkte 13.0 ... 13.k von denen aus Leitungen zu einer Umschaltvorrichtung 14 führen, die Umschalter 24a, 24b, 24c umfaßt, Impulse von dem elektrischen Steuergerät 11 erhält und Ausgangsspannungen an einen elektrischen Verbraucher 15 abgibt.

In Figur 1 ist als elektrischer Verbraucher ein dreisträngiger Motor 16 dargestellt, wobei jedem Strang eine entsprechende Verstärkerstufe 17a, 17b, 17c zugeordnet ist. An dem elektrischen Verbraucher 15 ist ein Sensor 18 angeordnet, der Betriebs-Größen des Verbrauchers 15, wie beispielsweise Position und/oder Drehzahl, erfaßt und Signale an das elektronische Steuergerät 11 abgibt.

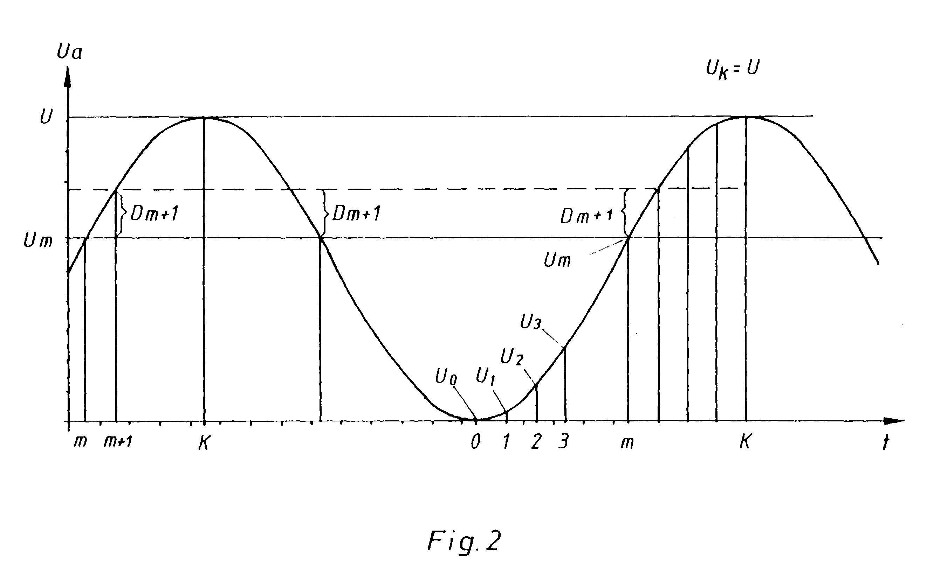

Die Funktion des Ausführungsbeispiels der erfindungsgemäßen Vorrichtung nach Figur 1 wird mit Hilfe von Figur 2 erläutert. Dort ist eine Ausgangsspannung Ua mit einer sinusförmigen Kurvenform dargestellt, wobei die Kurve so verschoben ist, daß negative Werte vermieden werden. Damit ergibt sich Ua = 1/2 (U + Uxsin(t)). Der Verlauf der Kurve in Figur 2 wird also zunächst bestimmt durch den Scheitelwert U und weiterhin durch die zeitliche Funktion sin(t).

Die Spannung U wird an der Spannungsquelle 10 durch das elektronische Steuergerät 11 eingestellt. Der zeitliche Verlauf der Sinuskurve wird dadurch realisiert, daß der Kurvenverlauf in einzelne Teilstücke aufgeteilt wird. So erkennt man in Figur 2 beispielsweise bei dem Punkt 0 der Abszisse ein Minimum der Kurve sin(t) und bei dem Punkt K ein Maximum, welches der Spannung U entspricht. Der Verlauf zwischen dem Minimum und dem Maximum wird in Stützpunkte 1, 2, 3, ... k aufgeteilt, an denen sich die Entnahmespannungen $U_1$, $U_2$, $U_3$ ... $U_k$ ergeben. Für eine beliebige Entnahmespannung $U_{m+1}$ gilt

$$U_{m+1} = U_m + D_{m+1}.$$

Somit sind die Bauelemente 12.1 ... 12.k der Schaltung nach Figur 1 derart dimensioniert, daß an ihnen die vorgegebenen Spannungen D, entsprechend $D_1$ ... $D_k$, abfallen. Damit ergeben sich als Gesamtspannungen an den Entnahmepunkten 13.0 ... 13.k die Entnahmespannungen $U_0$ ... $U_k$.

Die Umschaltvorrichtung 14 schaltet zwischen den einzelnen Entnahmepunkten 13, entsprechend 13.0, ... 13.k, derartig um, daß an jedem ihrer Ausgänge ein sinusförmiges Ausgangssignal Ua anliegt.

Soll beispielsweise der Ausgang, der dem Umschalter 24a zugeordnet ist, ein sinusförmiges Ausgangssignal Ua1 mit zunächst ansteigenden Werten liefern, so wird er durch das elektronische Steuergerät 11 derart geschaltet, daß er von einem beliebigen Eingangsanschluß (entsprechend dem Entnahmepunkt 13.m) zunächst in Richtung höherer Spannungswerte (entsprechend den Entnahmepunkten 13.m+1, 13.m+2 ..., 13.k) geschaltet wird, anschließend zu niedrigeren Spannungswerten, dann wieder zu höheren Spannungswerten, usw..

Analog verläuft dieser Prozeß für die Umschalter 24b und 24c. Sollen die durch die Umschalter 24a, 24b, 24c gelieferten Ausgangsspannungen Ua1, Ua2, Ua3 phasengekoppelt sein, so muß zwischen den Umschaltern 24 eine feste Kopplung vorliegen. Diese kann entweder durch Steuersignale des elektronischen Steuergerätes 11 oder durch in Figur 1 nicht dargestellte Mittel der Umschaltvorrichtung 14 vorgenommen werden.

Die von den Umschaltern 24a, 24b, 24c gelieferten Ausgangsspannungen Ua1, Ua2, Ua3 werden an den elektronischen Verbraucher 15 weitergegeben. In dem Ausführungsbeispiel nach Figur 1 handelt es sich dabei um den dreisträngigen Motor 16, wobei jedem Strang eine der Verstärkerstufen 17a, 17b, 17c zugeordnet ist. Die Ausgangsspannungen müssen dann eine Phasenverschiebung von 120° aufweisen. Durch die von den Verstärkerstufen 17a, 17b, 17c verstärkten Leistungen wird der Motor 16 angetrieben. Durch den Sensor 18, der beispielsweise als Tachogenerator ausgeführt sein kann, wird die Drehzahl und/oder die Position des Motors 16 erfaßt. Die von dem Sensor 18 gelieferten Signale werden an das elektronische Steuergerät 11 gegeben, das daraufhin durch Steuerimpulse bezüglich der Kommutierung die Umschaltvorrichtung 14 und/oder durch Steuerimpulse bezüglich Drehmoment bzw. Drehzahl die Spannungsquelle 10 ansteuert.

Bei einer Variante des Ausführungsbeispiels gemäß Figur 1 ist es möglich, daß neben den in Reihe geschalteten Bauelementen 12.1 ...12.k weitere nicht dargestellte Bauelemente vorgesehen sind, die den erstgenannten parallel geschaltet sind. Dadurch kann erreicht werden, daß die Entnahmespannungen $U_0$... $U_k$ der gewünschten Kurvenform, hier dem Sinusverlauf, besser angeglichen werden.

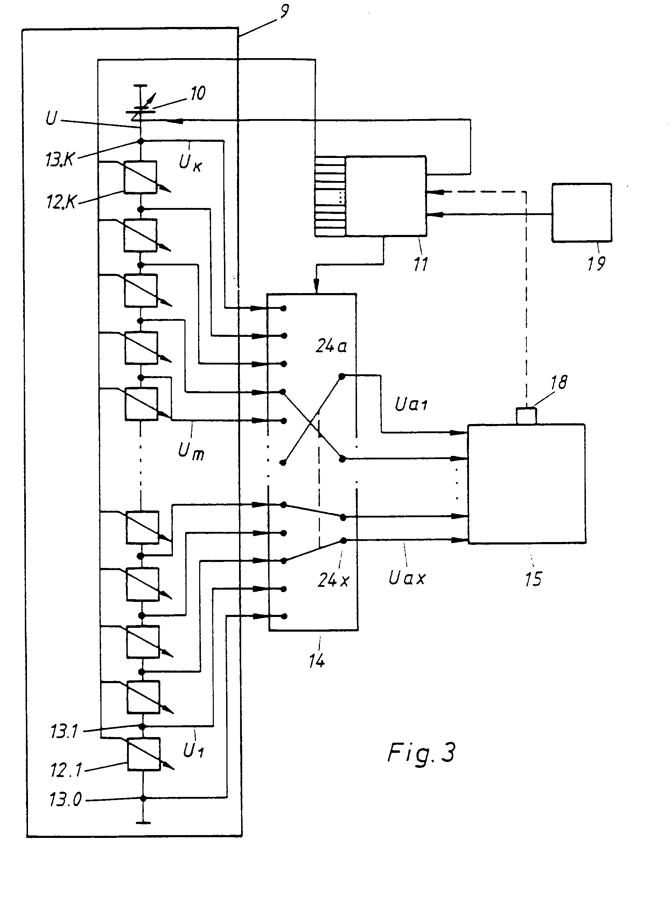

Ein zweites Ausführungsbeispiel ist in Figur 3 dargestellt. Dort sind Mittel und Baugruppen, die ähnliche Funktionen aufweisen wie die des Ausführungsbeispiels nach Figur 1, mit gleichen Bezugszahlen gekennzeichnet. Auf sie soll im folgenden nur insofern eingegangen werden, wie es für das Verständnis der vorliegenden Erfindung wichtig ist.

Wesentlich bei dem Ausführungsbeispiel gemäß Figur 3 ist, daß eine Eingabevorrichtung 19 vorgesehen ist, die Impulse an das elektronische Steuergerät 11 abgibt. Weiterhin sind die Bauelemente 12.1 ... 12.k in ihren elektrischen Eigenschaften, wie beispielsweise Widerstand und Kapazität, durch Steuerimpulse, die von dem elektronischen Steuergerät 11 abgegeben werden, veränderlich.

Das bewirkt, daß die einzelnen an den jeweiligen Bauelementen 12 abfallenden Spannungen D veränderlich sind. Da die Entnahmespannungen $U_1$ ... $U_k$ sich aus den Einzelspannungen D ergeben, ist es so möglich, Werte eines gewünschten, über die Eingabevorrichtung 19 vorgebbaren, zeitlichen Verlaufes der Ausgangsspannungen zu ermöglichen. über die Eingabevorrichtung 19 kann ebenfalls der Wert der Spannung U vorgegeben werden. Weiterhin ist in dem Ausführungsbeispiel nach Figur 3 angedeutet, daß die Umschaltvorrichtung 14 mehr als drei Umschalter enthalten kann, so daß auch mehrere Ausgangsspannungen Ua1, ..., Uax erzeugt werden können.

Alternativ kann das Ausführungsbeispiel auch derart gestaltet sein, daß das elektronische Steuergerät 11 seine Ausgangsimpulse an die Entnahmestufe 9 in Abhängigkeit von Signalen des Sensors 18 und/oder durch Signale eines nicht dargestellten Zeitgliedes steuert.

Weiterhin ist es denkbar, daß in der Entnahmestufe 9, eine weitere Spannungsquelle vorgesehen ist und/oder daß zumindest einzelne der Bauelemente 12.1 ... 12.k als Spannungsquelle ausgeführt sind. Damit wird erreicht, daß die

Entnahmespannungen $U_1$, ...$U_k$ auch einen unsymmetrischen Verlauf darstellen können.

Bei einer weiteren Variante, die sich sowohl auf das Ausführungsbeispiel gemäß Figur 1 als auch auf das gemäß Figur 3 bezieht, ist es weiterhin denkbar, daß die Entnahmespannungen Werte verschiedener Kurvenverläufe darstellen. Dies kann derart verwirklicht werden, daß $U_0$, $U_2$, ... einer ersten Kurvenform und $U_1$, $U_3$, ... einer zweiten Kurvenform entsprechen. Denkbar ist weiterhin eine Unterteilung in $U_0$, ... $U_m$ für Kurve 1 und $U_{m+1}$, ..., $U_k$ für Kurve 2. Wenn mehr als zwei Kurvenformen verwirklicht werden sollen, gelten entsprechende Aufteilungen.

Weiterhin ist denkbar, daß die Ausgangsspannungen Uao, ..., Uax zwar amplitudengekoppelt sind, d.h. durch ein einziges Ansteuersignal wird eine gemeinsame Änderung der Scheitelpunktswerte der einzelnen Ausgangsspannungen bewirkt, daß sie aber nicht denselben Scheitelpunkt aufweisen. Das kann durch nicht dargestellte Verstärkungs- bzw. Dämpfungsglieder realisiert werden, die beispielsweise Teil der Umschaltvorrichtung 14 sein können und die auch durch das elektronische Steuergerät 11 angesteuert werden können.

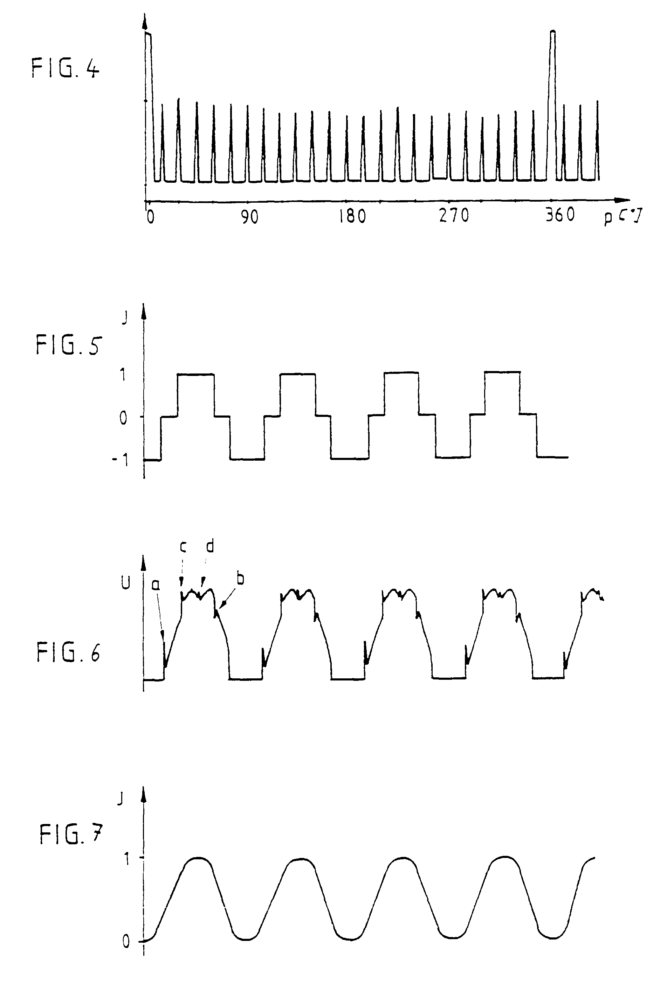

Im folgenden wird davon ausgegangen, daß der Motor 16 durch die Ausgangsspannungen Ua1, Ua2, Ua3 angesteuert wird und daß dessen Drehzahl und/oder Position durch den Sensor 18 erfaßt wird. Dieser gibt ein Ausgangssignal ab, wie es in Fig. 4 als Funktion der Position p dargestellt ist.

Bei der Grundstellung des Motors 16, d.h. p = 0°, sei eine besondere Marke angebracht, die zu einem von den anderen Ausgangsimpulsen abweichenden Signal führt. Weiterhin sind die Marken auf einem Rotor oder einer Rotorscheibe derart angebracht, daß sich alle 15° der Motorposition ein entsprechendes Ausgangssignal des Sensors 18 ergibt.

In Abhängigkeit von diesen Ausgangssignalen des Sensors 18 kann das elektronische Steuergerät 11 bei gemessenen Drehzahlen n Signale mit einer ersten Kurvenform gemäß der Figur 5 mittels der einzelnen Verstärkerstufen 17 für die Stränge des Motors 10 abgeben.

Der steile übergang zwischen Amplitudenwerten -1, 0 und +1 des Ansteuersignals gemäß Fig. 5 führt zu einem Spannungsverlauf gemäß Fig. 6. Man erkennt deutlich, daß verschiedene Störspitzen a, b, c, d auftreten. Während in diesem Beispiel die Störspitzen c, d übersprechspitzen durch Ansteuersignale anderer Motorstränge sind, können die durch den betreffenden Strang verursachten Störspitzen a, b andere Signale einer Vorrichtung, beispielsweise eines Videorekorders, beeinflussen, in die der Motor 16 und die dargestellten Mittel zu seiner Ansteuerung angeordnet sind.

Ein Ansteuerungssignal mit einer bevorzugten zweiten Kurvenform ist in Figur 7 dargestellt.

Bei dem bevorzugten Ausführungsbeispiel ist das Signal der Fig. 7 bezüglich der Position des Motors 16 in Phase mit dem Signal der Fig. 5. Das heißt, daß Extremwerte bzw. Nulldurchgänge zu einer gleichen Position p, d.h. Winkelstellung eines Rotors des Motors 16, erfolgen.

Eine derartige zweite Kurvenform, die gegenüber der ersten Kurvenform einen abgerundeten Verlauf aufweist, kann durch eine geeignete Ansteuerung der Spannungsquelle 10 und/oder der Umschaltvorrichtung 14 erfolgen.

Weiterhin ist es denkbar, daß die Ausgangssignale Ua oder die durch die Verstärker 17 aufbereiteten Signale durch nicht dargestellte Rundungsmittel abgerundet werden. Diese enthalten beispielsweise analoge Stufen mit geeigneten RC-Gliedern oder digitale Stufen mit einem geeigneten Zähler, der eine Oszillatorfrequenz zählt, dessen Frequenz größer ist als die maximale Geschwindigkeit der Abtastimpulse, jedoch langsamer als die möglichen Störspitzen.

Dadurch können beispielsweise Ansteuerungsignale erzielt werden, die einen nahezu sinusförmigen Verlauf aufweisen.

Somit wird insgesamt eine Vorrichtung zur Erzeugung amplitudengekoppelter Spannungen mit vorgegebenen zeitlichen Verläufen vorgestellt, die eine Entnahmestufe mit vorzugsweise einem Netzwerk von Bauelementen aufweist, an denen Einzelspannungen abfallen, und so Entnahmespannungen bereitstehen, die Spannungswerte mindestens einer vorgegebenen Kurve darstellen.

Der zeitliche Verlauf wird durch Steuersignale eines elektronischen Steuergerätes bestimmt, wodurch Umschalter die Entnahmespannungen derart schalten, daß die vorgegebenen Ausgangsspannungen bereitstehen. Diese können phasengekoppelt sein oder Kurvenformen mit verschiedenen zeitlichen Verläufen aufweisen, was durch das elektronische Steuergerät und/oder durch nicht dargestellte Mittel verwirklicht werden kann.

Die erfindungsgemäße Vorrichtung hat besonders den Vorteil, daß eine gemeinsame Änderung der Scheitelwerte der gelieferten Ausgangsspannungen von einem einzigen Ansteuersignal des elektronischen Steuergerätes bestimmt wird. Dadurch ist bei Verwendung digitaler Bausteine auch nur ein Digital-Analog-Wandler, der Teil des Steuergerätes 11 oder der Spannungsquelle 10 sein kann, zur gemeinsamen Ansteuerung der Ausgangsspannungen notwendig.

Eine Ausgestaltung der erfindungsgemäßen Vorrichtung erlaubt die Erzeugung von amplitudengekoppelten Ausgangsspannungen gemäß von außen vorgebbarer Kurvenverläufe.

Werden Verläufe der Ausgangsspannungen mit Hilfe von Signalen von Sensoren gesteuert, die Betriebsgrößen eines anzusteuernden Mittels erfassen, so kann eine verbesserte Ansteuerung dieses Mittels erreicht werden.

Wenn das anzusteuernde Mittel ein Elektromotor ist, so können verschiedene Kurven der Ausgangsspannungen in Abhängigkeit davon realisiert werden, ob eine Anlaufphase oder Normalbetrieb vorliegt.

**Patentansprüche**

1. Verfahren zur Erzeugung von amplitudengekoppelten Spannungen zur Ansteuerung eines Elektromotors (16) mit mehreren Strängen, wobei dem Motor (16) während einer Anlaufphase Ansteuersignale (Ua1,..., Ua3) mit einer ersten Kurvenform und während eines Normalbetriebs die Ansteuersignale (Ua1,..., Ua3) mit einer zweiten Kurvenform zugeführt werden, wobei eine Gesamtspannung (U) an Versorgungspunkte einer Entnahmevorrichtung (9) angelegt wird, dadurch gekennzeichnet, daß

   - der Spannungswert der Gesamtspannung (U) veränderbar ist,
   - Entnahmespannungen (U0, ..., Uk), die Werten der ersten Kurvenform oder der zweiten Kurvenformen entsprechen, an Entnahmepunkten (13) der Entnahmevorrichtung (9) entnehmbar sind und
   - die Entnahmespannungen (U0, ..., Uk) derart zeitlich geschaltet werden, daß die Ansteuersignale (Ua1, ..., Ua3) für den Elektromotor (16) mit entsprechenden Kurvenformen erzeugt werden.

2. Verfahren nach Anspruch 1, dadurch gekennzeichnet, daß die Anlaufphase von dem Normalbetrieb zeitlich und/oder aufgrund einer Betriebsgröße des Motors unterschieden wird.

3. Verfahren nach einem der Ansprüche 1 oder 2, dadurch gekennzeichnet, daß Signale der zweiten Kurvenform erzeugt werden durch geeignete Veränderung der Gesamtspannung (U) und/oder durch geeignetes Schalten der Entnahmespannungen (U0, ...,Uk).

4. Verfahren nach einem der Ansprüche 1 bis 3, dadurch gekennzeichnet, daß Signale der zweiten Kurvenform erzeugt werden, indem die Ansteuersignale (Ua1,..., Ua3) durch Rundungsmittel abgerundet werden.

5. Vorrichtung zur Erzeugung von amplitudengekoppelten Spannungen zur Ansteuerung eines Elektromotors (16) mit mehreren Strängen, wobei dem Motor (16) während einer Anlaufphase Ansteuersignale (Ua1, ..., Ua3) einer ersten Kurvenform und während eines Normalbetriebs die Ansteuersignale (Ua1, ..., Ua3) mit einer zweiten Kurvenform zugeführt werden, wobei mittels einer Spannungsquelle (10) eine Gesamtspannung (U) an Versorgungspunkte einer Entnahmevorrichtung (9) angelegt wird, dadurch gekennzeichnet, daß

   - ein Steuergerät (11) vorgesehen ist zur Ansteuerung der Spannungsquelle (10),
   - die Entnahmevorrichtung eine Vielzahl von Bauelementen (12) aufweist, die miteinander derart verbunden sind, daß Entnahmepunkte (13) vorhanden sind, an denen Entnahmespannungen (U0, ..., Uk), die Werten der ersten Kurvenform oder der zweiten Kurvenformen entsprechen, entnehmbar sind und
   - eine Umschaltvorrichtung (14) vorgesehen ist, mittels derer die Entnahmespannungen (U0, ..., Uk) derart zeitlich geschaltet werden, daß die Ansteuersignale (Ua1, ..., Ua3) für den Elektromotor (16) mit entsprechenden Kurvenformen erzeugt werden.

6. Vorrichtung nach Anspruch 5, dadurch gekennzeichnet, daß ein Zeitglied und/oder ein Sensor (18) vorgesehen ist, durch die eine Unterscheidung zwischen der Anlaufphase und dem Normalbetrieb durch zeitliche Steuerung und/oder aufgrund einer Betriebsgröße des Motors (16) bewirkt wird.

7. Vorrichtung nach einem der Ansprüche 5 oder 6, dadurch gekennzeichnet, daß das Steuergerät (11) die Spannungsquelle (10) und/oder den Umschalter (14) derart ansteuert, daß Signale der zweiten Kurvenform erzeugt werden durch geeignete Veränderung der Gesamtspannung (U) und/oder durch geeignetes Schalten der Entnahmespannungen (U0, ..., Uk).

8. Vorrichtung nach einem der Ansprüche 5 bis 7, dadurch gekennzeichnet, daß Rundungsmittel vorgesehen sind, die die Ansteuersignale (Ua1, ..., Ua3) abrunden wodurch die Signale der zweiten Kurvenform erzeugt werden.

**Claims**

1. A method for generating amplitude-coupled voltages for the control of an electric motor (16) with a plurality of phase-windings, wherein, during a start phase, control signals (Ua1, ..., Ua3) with a first curve shape and, during a normal operation, control signals (Ua1, ..., Ua3) with a second curve shape are supplied to the motor (16), a full voltage (U) being applied to supply points of a tapping device (9),
characterised in that

- the voltage value of the full voltage (U) is adjustable,
- tapping device (9), tapping voltages (U0, ..., Uk) which correspond to values of the first curve shape or the second curve shape, and
- the tapping voltages (U0, ..., Uk) are tapped in time such that the control signals (Ua1, ..., Ua3) for the electric motor (16) are generated with corresponding curve shapes.

2. A method according to claim 1, characterised in that the start phase is distinguished from the normal operation temporally and/or on the basis of an operating parameter of the motor.

3. A method according to claim 1 or 2, characterised in that signals of the second curve shape are generated by appropriate adjustment of the full voltage (U) and/or by appropriate switching of the tapping voltages (U0, ..., Uk).

4. A method according to any one of claims 1 to 3, characterised in that signals of the second curve shape are generated in that the control signals (Ua1, ..., Ua3) are rounded by rounding means.

5. A device for generating amplitude-coupled voltages for the control of an electric motor (16) with a plurality of phase-windings, wherein during a start phase, control signals (Ua1, ..., Ua3) with a first curve shape and, during a normal operation, control signals (Ua1, ..., Ua3) with a second curve shape are supplied to the motor (16), wherein a full voltage is applied by means of a voltage source (10) to supply points of a tapping device (9), characterised in that

- a control device (11) is provided for control of the voltage source (10),
- the tapping device has a multiplicity of components (12) which are interconnected so that tapping points (13) are provided at which there can be tapped tapping voltages (U0, ..., Uk) which correspond to values of the first curve shape or the second curve shape and
- a switching device (14) is provided, by means of which the tapping voltages (U0, ..., Uk) are so switched in time that control signals (Ua1, ..., Ua3) for the electric motor (16) are generated with corresponding curve shapes.

6. A device according to claim 5, characterised in that there is provided a timing element and/or a sensor (18), by means of which there is effected differentiation between the start phase and the normal operation by temporal control and/or on the basis of an operating parameter of the motor (16).

7. A device according to claim 5 or 6, characterised in that the control device (11) the voltage source (10) and/or the switching device (14) are controlled such that signals of the second curve shape are generated by suitable alteration of the full voltage (U) and/or by suitable switching of the tapping voltages (U0, ..., Uk).

8. A device according to any one of claims 5 to 7, characterised in that rounding means are provided, which round off the control signals (Ua1, ..., Ua3) whereby the signals of the second curve shape are generated.

**Revendications**

1. Procédé pour la production de tensions à amplitudes couplées pour l'excitation d'un moteur électrique (16) à plusieurs brins, où pendant une phase de démarrage des signaux de commande (Ua1 à Ua3) ayant une première caractéristique et pendant un fonctionnement normal les signaux (Ua1 à Ua3) ayant une deuxième caractéristique sont transmis au moteur (16). Une tension totale (U) est par ailleurs appliquée aux points d'alimentation d'un dispositif de prélèvement (9) caractérisé en ce que

- le voltage de la tension totale (U) est modifiable,
- les tensions de prélèvement (U0 à Uk) correspondant aux valeurs de la première caractéristique de courbe ou de la deuxième caractéristique de courbe peuvent être prélevées aux points de prélèvement (13) du dispositif de prélèvement (9),
- les tensions de prélèvement (U0 à Uk) sont commutées temporellement de sorte que les signaux de commande (Ua1 à Ua3) soient produits pour le moteur électrique (16) en ayant les caractéristiques de courbe correspondantes.

2. Procédé d'après la revendication 1, caractérisé en ce que la phase de démarrage est différenciée du fonctionnement normal temporellement et/ou sur la base d'une mesure de fonctionnement du moteur.

**3.** Procédé d'après une des revendications 1 ou 2, caractérisé en ce que les signaux ayant la deuxième caractéristique sont produits par une modification appropriée de la tension totale (U) et/ou par une commutation appropriée des tensions de prélèvement (U0 à Uk).

**4.** Procédé d'après une des revendications 1 à 3, caractérisé en ce que les signaux ayant la deuxième caractéristique sont produits tandis que les signaux de commande (Ua1 à Ua3) sont arrondis par des moyens d'arrondissement.

**5.** Dispositif pour la production de tensions à amplitudes couplées pour l'excitation d'un moteur électrique (16) à plusieurs brins, où pendant une phase de démarrage des signaux de commande (Ua1 à Ua3) ayant une première caractéristique et pendant un fonctionnement normal les signaux (Ua1 à Ua3) ayant une deuxième caractéristique sont transmis au moteur (16). Au moyen d'une source de tension (10), une tension totale (U) est par ailleurs appliquée aux points d'alimentation d'un dispositif de prélèvement (9) caractérisé en ce que

- un appareil de commande (11) est prévu pour l'excitation de la source de tension (10),
- le dispositif de prélèvement présente de nombreux composants (12) reliés entre eux de sorte que des points de prélèvement (13) existent, auxquels les tensions de prélèvement (U0 à Uk) correspondant aux valeurs de la première caractéristique de courbe ou de la deuxième caractéristique de courbe peuvent être prélevées,
- un dispositif de commutation (14) est prévu, au moyen duquel les tensions de prélèvement (U0 à Uk) sont commutées temporellement de sorte que les signaux de commande (Ua1 à Ua3) soient produits pour le moteur électrique (16) en ayant les caractéristiques de courbe correspondantes.

**6.** Dispositif d'après la revendication 5, caractérisé en ce qu'un membre temporisateur et/ou un détecteur (18) est prévu, par lequel la phase de démarrage est différenciée du fonctionnement normal par commande temporelle et/ou sur la base d'une mesure de fonctionnement du moteur (16).

**7.** Dispositif d'après une des revendications 5 ou 6, caractérisé en ce que l'appareil de commande (11) excite la source de tension (10) et/ou le commutateur (14) de sorte que les signaux ayant la deuxième caractéristique soient produits par une modification appropriée de la tension totale (U) et/ou par une commutation appropriée des tensions de prélèvement (U0 à Uk).

**8.** Dispositif d'après une des revendications 5 à 7, caractérisé en ce que des moyens d'arrondissement qui arrondissent les signaux de commande (Ua1 à Ua3) sont prévus, ce qui produit les signaux ayant la deuxième caractéristique.

Fig.1

*Fig. 2*

Fig. 3

FIG. 4

FIG. 5

FIG. 6

FIG. 7